# EUROPÄISCHE PATENTSCHRIFT

(11) **EP 2 931 559 B1**
(45) Veröffentlichungstag und Bekanntmachung des Hinweises auf die Patenterteilung: **28.02.2018**
(21) Anmeldenummer: 13811405.3
(22) Anmeldetag: 04.12.2013
(51) Int. Cl.: B60R 1/08, H01L 51/42

(54) **ABDUNKELBARE SPIEGELVORRICHTUNG**
DARKENABLE MIRROR DEVICE
DISPOSITIF MIROIR AVEC ASSOMBRISSEMENT

(30) Priorität: 11.12.2012 DE 102012222760
(43) Veröffentlichungstag der Anmeldung: 21.10.2015
(73) Patentinhaber: OSRAM OLED GmbH, 93049 Regensburg (DE)
(72) Erfinder: POPP, Michael, 85354 Freising (DE); KRUMMACHER, Benjamin, Claus, 93051 Regensburg (DE)
(74) Vertreter: Epping - Hermann - Fischer
(86) Internationale Anmeldenummer: PCT/EP2013/075582
(87) Internationale Veröffentlichungsnummer: WO 2014/090666

(56) Entgegenhaltungen:
- WO-A1-2005/015173
- US-A1- 2003 122 749
- US-A1- 2004 031 965
- US-A1- 2010 321 758
- US-A1- 2011 025 212

## Beschreibung

Es wird eine abdunkelbare Spiegelvorrichtung angegeben.
Um beispielsweise bei einem Innenrückspiegel eines Autos eine Blendung des Fahrers durch die Scheinwerfer des nachfolgenden Verkehrs zu reduzieren, kann der Rückspiegel eine verdunkelbare Spiegelfläche aufweisen, die in Abhängigkeit von einem Messsignal eines Helligkeitssensors in der Nähe der Spiegelfläche oder im Bereich des Innenrückspiegels gesteuert wird. Zur Steuerung der Spiegelhelligkeit sind auch polykristalline großflächige Detektoren oder Solarzellen bekannt.
Hierbei handelt es sich aber üblicherweise um separate, externe Sensoren, die auch abgesehen von der Spiegelhelligkeit keine weitere Funktionalität aufweisen.

Das Dokument US2010321758 wird als nächstliegender Stand der Technik gegenüber dem Gegenstand des Anspruchs 1 angesehen. Es offenbart eine Spiegelvorrichtung, die abdunkelbar ist, aufweisendein Substrat mit einem elektrochromen Material, das eine steuerbare Transparenz aufweist, - auf dem Substrat zumindest ein organisches optoelektronisches Element, und eine reflektierende Schicht auf einer dem Substrat abgewandten Seite des organischen funktionellen Schichtenstapels aufweist.

Zumindest eine Aufgabe von bestimmten Ausführungsformen ist es, eine abdunkelbare Spiegelvorrichtung anzugeben.
Diese Aufgabe wird durch einen Gegenstand gemäß dem unabhängigen Patentanspruch gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.
Die erfindungsgemäße Spiegelvorrichtung ist abdunkelbar. Sie weist ein Substrat mit einem elektrochromen Material auf, das eine steuerbare Transparenz aufweist. Weiter umfasst die Spiegelvorrichtung zumindest ein organisches optoelektronisches Element auf dem Substrat, das einen organischen funktionellen Schichtenstapel mit zumindest einer organischen optoelektronischen Schicht zwischen zwei Elektroden aufweist, die als organische Licht detektierende Schicht ausgebildet ist und die in einem ersten Betriebszustand der Spiegelvorrichtung durch das Substrat Umgebungslicht detektiert, so dass das organische optoelektronische Element im ersten Betriebszustand als organisches Licht detektierendes Element wirkt. Die Transparenz des Substrats ist in Abhängigkeit von einem Messsignal des organischen optoelektronischen Elements im ersten Betriebszustand steuerbar. Die Spiegelvorrichtung umfasst ferner eine reflektierende Schicht auf einer dem Substrat abgewandten Seite des organischen funktionellen Schichtenstapels.

Die abdunkelbare Spiegelvorrichtung weist ein Substrat mit einem elektrochromen Material auf, das eine steuerbare Transparenz aufweist. Das Substrat kann hierzu als elektrochromes Material beispielsweise ein elektrochromes Glas, beispielsweise WLiO₃, und/oder eine elektrochrome Folie mit einem elektrochromen Polymer oder eine Mehrzahl oder ein Laminat mit diesen aufweisen oder daraus sein. Weiterhin kann das Substrat zusätzlich auch eine oder mehrere transparente Glas- und/oder Kunststoffschichten aufweisen. Das Substrat kann beispielsweise in einem Zustand des elektrochromen Materials möglichst transparent und insbesondere hell durchscheinend für Licht sein. In einem weiteren Zustand des elektrochromen Materials kann das Substrat weniger transparent und insbesondere verdunkelt erscheinen. Das elektrochrome Material kann über die gesamte Haupterstreckungsebene des Substrats angeordnet sein oder in einem oder mehreren Teilbereichen, so dass das Substrat entlang seiner Haupterstreckungsebene auch einen oder mehrere Teilbereiche aufweisen kann, die kein elektrochromes Material enthalten und beispielsweise unveränderlich transparent sind.

Mit "transparent" wird hier und im Folgenden eine Schicht bezeichnet, die durchlässig für sichtbares Licht ist. Dabei kann die transparente Schicht klar durchscheinend oder auch zumindest teilweise Licht streuend und/oder teilweise Licht absorbierend sein, so dass eine als transparent bezeichnete Schicht beispielsweise auch diffus oder milchig durchscheinend sein kann. Besonders bevorzugt ist eine hier als transparent bezeichnete Schicht möglichst derart durchlässig für sichtbares Licht ausgebildet, dass insbesondere die Absorption von im organischen Licht emittierenden Element erzeugtem Licht so gering wie möglich ist.

Darüber hinaus weist die Spiegelvorrichtung eine reflektierende Schicht auf, die sich von einem Betrachter aus gesehen hinter dem Substrat und insbesondere hinter dem elektrochromen Material befindet. Das elektrochrome Material des Substrats kann insbesondere im Bereich der reflektierenden Schicht angeordnet sein. Das bedeutet, dass das elektrochrome Material die reflektierende Schicht von einem Betrachter aus gesehen überdeckt, so dass von außen einfallendes Licht, also Umgebungslicht, das an der reflektierende Schicht reflektiert wird, das elektrochrome Material passiert. Durch Änderung der Transparenz des Substrats mithilfe des elektrochromen Materials, das durch elektrische Kontaktelemente angesteuert werden kann, kann die Spiegelwirkung der Spiegelvorrichtung geregelt werden. Insbesondere kann die Spiegelvorrichtung mit abnehmender Transparenz des Substrats durch eine entsprechende Steuerung des elektrochromen Materials immer dunkler erscheinen.

Beispielsweise kann die Spiegelvorrichtung als Rückspiegel, insbesondere als Innenrückspiegel, eines Kraftfahrzeugs, beispielsweise eines Lastkraftwagens oder eines Personenkraftwagens, ausgebildet sein, bei dem durch das elektrochrome Material eine Reduktion der Blendung erreicht werden kann, die beispielsweise durch Scheinwerferlicht des nachfolgenden Verkehrs hervorgerufen werden kann.

Weiterhin weist die Spiegelvorrichtung auf dem Substrat zumindest ein organisches optoelektronisches Element auf, das einen organischen funktionellen Schichtenstapel mit zumindest einer organischen optoelektronischen Schicht zwischen zwei Elektroden aufweist. "Auf dem Substrat" bedeutet hier und im Folgenden insbesondere, dass das zumindest eine organische optoelektronische Element auf einer dem Betrachter abgewandten Deckfläche des Substrats angeordnet ist und das zumindest eine organische optoelektronische Element zumindest stellenweise mit der Deckfläche in direktem Kontakt steht.

Die zumindest eine organische optoelektronische Schicht ist zumindest als organische Licht detektierende Schicht ausgebildet, die in einem ersten Betriebszustand der Spiegelvorrichtung durch das Substrat Umgebungslicht detektieren kann, so dass das organische optoelektronische Element im ersten Betriebszustand als organisches Licht detektierendes Element wirkt. Das organische optoelektronische Element kann somit dazu eingerichtet sein, im ersten Betriebszustand bei Einstrahlung von Umgebungslicht auf dieses in ein elektrisch messbares Signal, beispielsweise in eine Fotospannung, in einen Fotostrom oder in einen lichtabhängigen elektrischen Widerstand, umzuwandeln.

Als "Umgebungslicht" wird hier und im Folgenden Licht bezeichnet, das von außen auf die Spiegelvorrichtung treffen kann, das also nicht innerhalb der Spiegelvorrichtung durch interne Streu- oder Lichtleitungseffekte von einem Licht emittierenden Element zum organischen optoelektronischen Element geleitet wird.

Weiterhin kann das organische optoelektronische Element in Einstrahlrichtung des Umgebungslicht hinter dem elektrochromen Materials angeordnet sein, so dass die zumindest eine organische optoelektronische Schicht durch das elektrochrome Material hindurch das Umgebungslicht detektieren kann. Alternativ hierzu ist es auch möglich, dass das organische optoelektronische Element lateral versetzt zum elektrochromen Material angeordnet ist, so dass die zumindest eine organische optoelektronische Schicht durch einen nicht in seiner Transparenz durch das elektrochrome Material regelbaren und somit dauerhaft transparenten Teilbereich des Substrats das Umgebungslicht detektieren kann.

Mit "lateral" wird hier und im Folgenden eine Richtung parallel zur Haupterstreckungsebene des Substrats bezeichnet. Eine laterale Richtung ist somit beispielsweise senkrecht zur Stapelrichtung der Elektroden und des organischen funktionellen Schichtenstapels des zumindest einen organischen optoelektronischen Elements gerichtet.

Die Transparenz des Substrats und insbesondere des elektrochromen Materials kann in Abhängigkeit von einem Messsignal des organischen optoelektronischen Elements im ersten Betriebszustand geregelt werden. Der erste Betriebszustand kann je nach Ausbildung der Spiegelvorrichtung der einzige Betriebszustand der Spiegelvorrichtung sein. Weiterhin kann die Spiegelvorrichtung noch weitere Betriebszustände, wie weiter unten erläutert ist, aufweisen, in denen das organische optoelektronische Element nicht als organisches Licht detektierendes Element sondern als organisches Licht emittierendes Element wirkt oder auch nicht betrieben wird.

Die reflektierende Schicht ist zumindest teilweise oder auch gänzlich auf einer dem Substrat abgewandten Seite des organischen funktionellen Schichtenstapels angeordnet, so dass sich in Anordnungsrichtung der Schichten des organischen optoelektronischen Elements die zumindest eine organische optoelektronische Schicht zwischen dem Substrat und der reflektierenden Schicht befindet. Die reflektierende Schicht kann zusammenhängend oder untertrennt in Teilbereichen sein.

Ferner kann das Substrat als Herstellungsträger für das optoelektronische Element ausgebildet sein. In diesem Fall ist es möglich, dass die funktionellen Schichtenstapel und die Elektroden des organischen optoelektronischen Elements auf der Deckfläche des Substrats nacheinander aufgebracht werden, so dass das Substrat dasjenige Substrat ist, das zur Herstellung des organischen optoelektronischen Elements vorgesehen ist. Mit anderen Worten werden die organischen Licht emittierenden und Licht detektierenden Elemente nicht auf eigenen Substraten hergestellt und dann auf dem gemeinsamen Substrat angeordnet, sondern auf dem gemeinsamen Substrat hergestellt.

Insbesondere kann zumindest eine Elektrode des organischen optoelektronischen Elements direkt an das Substrat grenzen, das heißt, sie kann mit der Deckfläche des Substrats in direktem Kontakt stehen. Eine dem Betrachter zugewandte Bodenfläche des Substrats bildet dann eine Außenfläche der Spiegelvorrichtung und bleibt größtenteils frei von Material. Die Bodenfläche dient dann bevorzugt als Lichteintrittsfläche für das Umgebungslicht. Es ist ferner möglich, dass das Substrat das einzige Substrat der Spiegelvorrichtung ist. Es ist jedoch auch möglich, dass die Spiegelvorrichtung eine Vielzahl von Substraten mit jeweils einem elektrochromen Material umfasst, wobei jedem der Substrate jeweils ein organisches optoelektronisches Element, welches zumindest eine organische optoelektronische Schicht zwischen zwei Elektroden aufweist, eineindeutig zugeordnet werden kann.

Das Substrat bildet insbesondere die mechanisch tragende Komponente des zugeordneten organischen optoelektronischen Elements.

Gemäß einer weiteren Ausführungsform weist die reflektierende Schicht die dem Substrat abgewandte Elektrode des organischen optoelektronischen Elements auf oder besteht daraus. Mit anderen Worten ist es möglich, dass das organische optoelektronische Element eine reflektierende Elektrode aufweist, die vom Substrat aus gesehen über dem organischen funktionellen Schichtenstapel angeordnet ist und die zumindest einen Teil der reflektierenden Schicht bildet.

Gemäß einer weiteren Ausführungsform weist die abdunkelbare Spiegelvorrichtung eine Spiegelfläche mit einer Spiegelschicht auf, die beispielsweise lateral benachbart zum organischen optoelektronischen Element auf dem Substrat angeordnet ist und die einen Teil der reflektierenden Schicht bildet.

Gemäß einer weiteren Ausführungsform weist die abdunkelbare Spiegelvorrichtung eine Spiegelschicht mit regelbarer Reflektivität auf einer dem Substrat gegenüber liegenden Seite des organischen optoelektronischen Elements auf, während die dem Substrat abgewandt angeordnete Elektrode des organischen optoelektronischen Elements transparent oder zumindest teilweise oder bereichsweise lichtdurchlässig ausgebildet ist. Die reflektierende Schicht der Spiegelvorrichtung kann die Spiegelschicht mit regelbarer Reflektivität aufweisen oder daraus sein. Insbesondere kann die Spiegelschicht mit regelbarer Reflektivität auch eine regelbare Transparenz aufweisen, so dass die Spiegelschicht wahlweise reflektierend oder transparent geschaltet werden kann. Beispielsweise kann die Spiegelschicht mit regelbarer Reflektivität ein elektrochromes Material und/oder ein Flüssigkristallmaterial und/oder schaltbare Spiegelelemente aufweisen. Die Spiegelschicht mit regelbarer Reflektivität kann dazu eingerichtet sein, die dem Substrat gegenüber liegende Seite der Spiegelvorrichtung in gewünschten Messintervallen von einem reflektierenden Zustand in einen zumindest teilweise transparenten Zustand zu schalten, während dem das organischen optoelektronische Element auch Umgebungslicht auf der dem Substrat abgewandten Seite der Spiegelvorrichtung detektieren kann. Eine solche Messung kann beispielsweise als Referenzmessung geeignet sein, mit der die allgemeine Helligkeit, beispielsweise also das Tageslicht, festgestellt werden kann, so dass das elektrochrome Material der Spiegelvorrichtung beispielsweise nur dann in seiner Transparenz geregelt wird, wenn die allgemeine Helligkeit einen gewissen Wert unterschreitet, also beispielsweise während der Nacht oder in einer dunklen Umgebung.

Gemäß einer weiteren Ausführungsform ist die dem Substrat zugewandte Elektrode des organischen optoelektronischen Elements transparent ausgebildet. Beispielsweise kann eine transparente Elektrode aus einem transparenten leitenden Oxid ("transparent conductive oxide", TCO) sein oder ein solches aufweisen. Weiterhin kann eine transparente Elektrode zusätzlich oder alternativ ein transparentes Metall, Netzstrukturen und/oder Graphen aufweisen. Eine reflektierende Elektrode kann beispielsweise ein reflektierendes Metall aufweisen.

Gemäß einer weiteren Ausführungsform ist die zumindest eine organischen optoelektronische Schicht des organischen funktionellen Schichtenstapels des organischen optoelektronischen Elements zusätzlich als organische Licht emittierende Schicht ausgebildet, die in einem zweiten Betriebszustand der Spiegelvorrichtung Licht abstrahlt. Das organische optoelektronische Element kann im zweiten Betriebszustand somit als organische Licht emittierende Diode (OLED) wirken und Licht durch das Substrat abstrahlen. Durch Schalten in den ersten oder zweiten Betriebszustand kann die Spiegelvorrichtung wahlweise als abblendbare Spiegelvorrichtung oder als Beleuchtungsvorrichtung betrieben werden.

Gemäß einer weiteren Ausführungsform weist die Spiegelvorrichtung lateral benachbart zum organischen optoelektronischen Element auf dem Substrat ein organisches Licht emittierendes Element auf, das durch das Substrat Licht abstrahlen kann. Insbesondere ist das organische Licht emittierende Element auf derselben Substratseite wie das organische optoelektronische Element angeordnet. Bevorzugt kann das organische Licht emittierende Element in einem vom ersten Betriebszustand verschiedenen Betriebszustand betrieben werden, so dass die Spiegelvorrichtung wahlweise als abblendbarer Spiegel oder als Beleuchtungsvorrichtung betrieben werden kann. Das organische Licht emittierende Element weist zwischen zwei Elektroden einen organischen funktionellen Schichtenstapel mit zumindest einer organischen Licht emittierenden Schicht auf. Das organische optoelektronische Element und das organische Licht emittierende Element können hinsichtlich ihres Aufbaus, also hinsichtlich der Elektroden und/oder des jeweiligen organischen funktionellen Schichtenstapels gleich ausgebildet sein. Alternativ dazu können die Elemente auch verschieden ausgebildet sein. Beispielsweise kann das organische Licht emittierende Element auf der dem Substrat abgewandten Seite eine Elektrode aufweisen, die reflektierend ausgebildet ist. Die reflektierende Elektrode kann Teil der reflektierenden Schicht der Spiegelvorrichtung sein oder die reflektierende Schicht der Spiegelvorrichtung kann aus der reflektierenden Elektrode des organischen Licht emittierenden Elements bestehen.

Gemäß einer weiteren Ausführungsform weist die Spiegelvorrichtung lateral benachbart zum organischen optoelektronischen Element auf dem Substrat ein organisches Licht detektierendes Element auf. Das organische Licht detektierende Element kann beispielsweise dazu eingerichtet sein, Umgebungslicht zu detektieren, das von einer dem Substrat gegenüber liegenden Seite der Spiegelvorrichtung auf die Spiegelvorrichtung eingestrahlt wird. Wie bereits weiter oben beschrieben kann hierdurch beispielsweise die allgemeine Helligkeit, also beispielsweise das Tageslicht, als Referenzlicht gemessen werden, so dass die Spiegelvorrichtung und insbesondere das elektrochrome Material des Substrats und damit die Verdunkelungsfunktion in Abhängigkeit von der allgemeinen Helligkeit betrieben werden kann.

Gemäß einer weiteren Ausführungsform weist die abdunkelbare Spiegelvorrichtung vom Substrat aus gesehen auf dem organischen optoelektronischen Element ein organisches Licht detektierendes Element und/oder ein weiteres organisches optoelektronisches Element auf, das jeweils Umgebungslicht detektieren kann, das von der dem Substrat gegenüber liegenden Seite auf die Spiegelvorrichtung eingestrahlt wird. Die aufeinander angeordneten organischen optoelektronischen Elemente oder das organische optoelektronische Element und das darauf angeordnete organische Licht detektierende Element können beispielsweise gleich ausgebildet sein. Das organische Licht detektierende Element und/oder das weitere organische optoelektronische Element können jeweils zwischen zwei Elektroden einen organischen funktionellen Schichtenstapel mit zumindest einer organischen Licht detektierenden Schicht beziehungsweise einer organischen optoelektronischen Schicht aufweisen, wobei eine der Elektroden durch eine der Elektroden des organischen optoelektronischen Elements auf dem Substrat gebildet wird. Mit anderen Worten können das organische optoelektronische Element auf dem Substrat und das drüber angeordnete organische Licht detektierende oder optoelektronische Element eine gemeinsame Elektrode aufweisen.

Gemäß einer weiteren Ausführungsform ist ein Element der Spiegelvorrichtung, das Licht detektieren kann, also das organische optoelektronische Element und gegebenenfalls ein weiteres organisches Licht detektierendes oder optoelektronisches Element, als organische Fotodiode und/oder als organischer Fotoleiter und/oder als organischer Fotowiderstand ausgebildet und einsetzbar.

Eine organische Fotodiode kann insbesondere einen organischen funktionellen Schichtenstapel zwischen zwei Elektroden aufweisen, wobei der organische funktionelle Schichtenstapel als organische Licht detektierende Schicht zumindest einen pn-Übergang zur Erzeugung von Ladungsträgern aufweist. Beispielsweise kann die organische Fotodiode im Hinblick auf die Elektroden und den organischen funktionellen Schichtenstapel denselben Aufbau wie ein organisches Licht emittierende Element, also insbesondere eine OLED, aufweisen und invers dazu, also mit entgegengesetzter elektrischer Polung, betrieben werden. Hierdurch kann es möglich sein, beispielsweise alle organischen optoelektronischen, Licht detektierenden und Licht emittierenden Elemente des Spiegelvorrichtung gleich auszubilden, wodurch im Vergleich beispielsweise zu herkömmlichen Flächenstrahlern wie OLEDs bei der Herstellung eine unveränderte Prozessführung ohne Mehraufwand und ohne Mehrkosten möglich sein kann. Alternativ hierzu kann die organische Fotodiode im Vergleich zu einem organischen Licht emittierenden Element andere Materialien und/oder andere Schichtaufbauten im Hinblick auf die Elektroden und/oder den organischen funktionellen Schichtenstapel aufweisen, wodurch zwar ein zusätzlicher Aufwand bei der Fertigung vonnöten sein kann, jedoch auch die Sensitivität der organischen Fotodiode gezielt angepasst werden kann.

Ein organischer Fotoleiter kann ein organisches fotoleitendes Material aufweisen, das bei Einstrahlung von Licht elektrische Ladungen erzeugt. Organische fotoleitende Materialien können beispielsweise einschichtig auf einer elektrisch leitenden Schicht, beispielsweise einer Elektrode, ausgebildet sein. Weiterhin können organische fotoleitende Materialien beispielsweise zumindest zweischichtig mit wenigstens einer organischen Ladungsträger erzeugenden Schicht und einer organischen Ladungsträger transportierenden Schicht ausgebildet sein. Darüber hinaus kann ein als organischer Fotoleiter ausgebildetes organisches optoelektronisches und/oder Licht detektierendes Element denselben Aufbau wie ein organisches Licht emittierendes Element, beispielsweise eine OLED, aufweisen.

Je nach Materialien und Aufbau kann ein organischer Fotoleiter auch als organische Fotodiode aufgebaut sein. Ein solches organisches Element kann mit einer elektrischen Vorspannung als Fotodiode und ohne elektrische Vorspannung als Fotoleiter einsetzbar sein. Weiterhin kann je nach verwendeten Materialien und Aufbau auch zusätzlich oder alternativ der elektrische Widerstand gemessen werden.

Gemäß einer weiteren Ausführungsform weist die Spiegelvorrichtung eine Mehrzahl von organischen optoelektronischen Elementen und/oder einer Mehrzahl von organischen Licht detektierenden Elementen und/oder eine Mehrzahl von organischen Licht emittierenden Elementen lateral benachbart auf dem Substrat auf.

Das Substrat kann insbesondere das einzige Substrat der Spiegelvorrichtung für das organische optoelektronische Element und gegebenenfalls für weitere organische Elemente sein. Die Schichten des oder der organischen Elemente werden dabei insbesondere auf dem Substrat nacheinander aufgebracht, so dass das Substrat dasjenige Substrat ist, das zur Herstellung des oder der organischen Elemente erforderlich und vorgesehen ist. Mit anderen Worten werden das organische optoelektronische Element und gegebenenfalls weitere organische Licht emittierende und/oder Licht detektierende Elemente nicht auf eigenen Substraten hergestellt und dann auf dem Substrat mit dem elektrochromen Material angeordnet, sondern auf dem Substrat mit dem elektrochromen Material hergestellt. Somit ist dabei insbesondere zwischen dem Substrat und den organischen funktionellen Schichten der organischen Elemente kein weiteres Substrat angeordnet.

Bei der hier beschriebenen abdunkelbaren Spiegelvorrichtung wird zumindest ein Sensorelement in Form des organischen optoelektronischen Elements verwendet, das so ausgebildet ist, das es in zumindest einem Betriebszustand als organisches Licht detektierendes Element in Form einer organischen Fotodiode, eines organischen Fotoleiters oder eines organischen Fotowiderstands Umgebungslicht durch ein Substrat, das die Betrachtungsseite der Spiegelvorrichtung bildet, und gegebenenfalls auch auf der gegenüber liegenden Seite detektieren kann. Bei Einstrahlung von Umgebungslicht, insbesondere von Umgebungslicht mit einer bestimmten minimalen Helligkeit wie beispielsweise von Autoscheinwerfern, kann ein automatisches Abblenden der Spiegelvorrichtung möglich sein, indem das Signal des zumindest einen Sensorelements das die Beleuchtung an der Vorder- oder Rückseite detektiert, direkt zur Steuerung des elektrochromen Materials des Substrats verwendet wird. Das organische optoelektronische Element und gegebenenfalls weitere organische Licht detektierende oder optoelektronische Elemente können als Sensorelemente separat und beispielsweise großflächig im Bereich einer reflektierenden Schicht eingebaut sein oder die reflektierende Schicht kann ein Teil eines oder mehrerer der organischen Elemente sein. Zusätzlich zur Licht detektierenden Funktion kann das organische optoelektronische Element auch dazu ausgebildet sein, in einem weiteren Betriebszustand als Beleuchtungsquelle verwendet zu werden.

Beispielsweise kann im Fall eines zusätzlichen organischen Licht detektierenden oder Licht emittierenden Elements dieses denselben Schichtaufbau wie das organische optoelektronische Element haben, so dass durch eine monolithische Integration separierte Flächenbereichen mit demselben Schichtaufbau als Sensoren und/oder Lichtquellen eingesetzt werden können. Dadurch sind keine separaten Beleuchtungselemente oder Sensorelemente wie bei herkömmlichen abblendbaren Spiegeln nötig und die organischen Elemente können beispielsweise ein großflächiges Sensorelement und/oder ein großflächiges Beleuchtungselement bilden, ohne dass zusätzliche Kosten entstehen. Dadurch ist in der abdunkelbaren Spiegelvorrichtung selbst eine automatisierte Signalgeneration durch zumindest einen monolithisch integrierten Sensor zur Schaltung von Dimmelementen, also insbesondere des elektrochromen Materials im Substrat, möglich um beispielsweise eine Blendung zu verhindern.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Figur 1: eine schematische Darstellung einer abdunkelbaren Spiegelvorrichtung gemäß einem Ausführungsbeispiel,
- Figuren 2A und 2B: schematische Darstellungen einer abdunkelbaren Spiegelvorrichtung und der Lichtverhältnisse gemäß weiteren Ausführungsbeispielen,
- Figuren 3 bis 5: schematische Darstellungen von abdunkelbaren Spiegelvorrichtungen gemäß weiteren Ausführungsbeispielen,
- Figuren 6A bis 6M: schematische Darstellungen von abdunkelbaren Spiegelvorrichtungen gemäß weiteren Ausführungsbeispielen und
- Figuren 7 bis 9: schematische Darstellungen von abdunkelbaren Spiegelvorrichtungen gemäß weiteren Ausführungsbeispielen.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

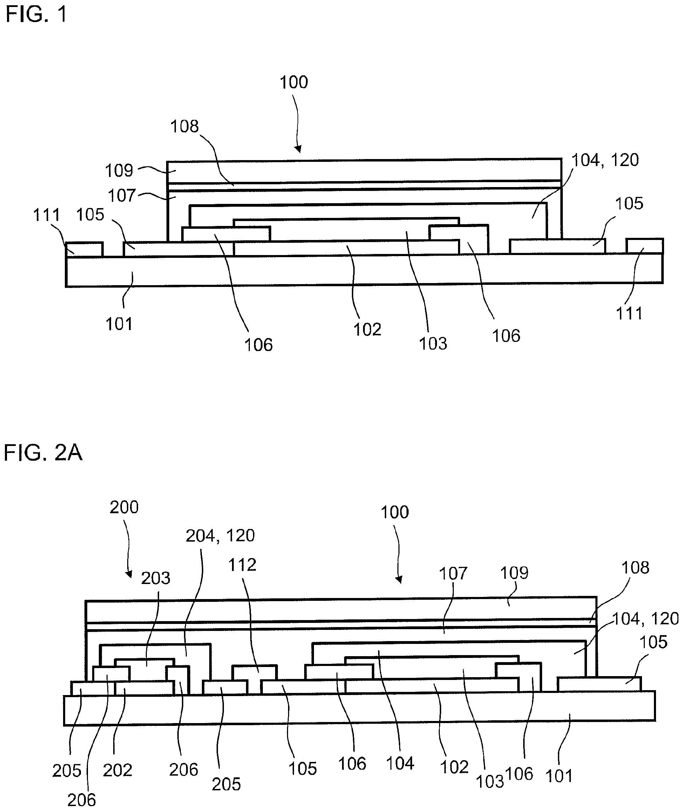

In Figur 1 ist eine abdunkelbare Spiegelvorrichtung gemäß einem Ausführungsbeispiel gezeigt, das beispielsweise als Rückspiegel eines Kraftfahrzeugs, etwa als Innenrückspiegel eines Personenkraftwagens oder Lastkraftwagens, ausgebildet sein kann. Beispielsweise für Innenrückspiegel oder andere Spiegelvorrichtungen übliche Gehäuseteile sind der Übersichtlichkeit halber nicht gezeigt.

Die Spiegelvorrichtung weist ein Substrat 101 auf, auf dem ein organisches optoelektronisches Element 100 und eine reflektierende Schicht 120 angeordnet sind, wobei die Substratseite die einem Betrachter zugewandte Seite der Spiegelvorrichtung ist, so dass in Betrachtungsrichtung die reflektierende Schicht 120 hinter dem Substrat 101 liegt.

Das Substrat 101 weist ein elektrochromes Material auf, das eine steuerbare Transparenz aufweist. Das Substrat 101 kann als elektrochromes Material beispielsweise ein elektrochromes Glas, beispielsweise WLiO₃, und/oder eine elektrochrome Folie mit einem elektrochromen Polymer oder eine Mehrzahl oder ein Laminat mit diesen aufweisen. Weiterhin kann das Substrat 101 zusätzlich auch eine oder mehrere transparente Glas- oder Kunststoffschichten aufweisen. Beispielsweise kann das Substrat 101 auch ein Schutzglas und alternativ oder zusätzlich eine andere Schutzschicht aufweisen. Insbesondere kann das Substrat 101 auch flexibel sein, so dass auch die Spiegelvorrichtung flexibel sein kann.

Das Substrat 101 kann in einem Zustand des elektrochromen Materials möglichst transparent und insbesondere hell durchscheinend für Licht sein. In einem weiteren Zustand des elektrochromen Materials kann das Substrat 101 weniger transparent und insbesondere verdunkelt erscheinen. Insbesondere kann das elektrochrome Material so ausgebildet sein, dass eine kontinuierliche Reduktion der Transparenz des Substrats 101 erreicht werden kann und somit eine kontinuierliche Verdunkelung der Spiegelvorrichtung. Zur Steuerung, das heißt insbesondere zur elektrischen Kontaktierung und zur Regelung der Transparenz, des elektrochromen Materials des Substrats 101 sind auf dem Substrat 101 Kontaktelemente 111 vorgesehen. Die Kontaktelemente 101 sind zum Beispiel lateral zu dem organischen optoelektronischen Element 100 beabstandet und stehen mit der Deckfläche des Substrats 101 in direktem Kontakt.

Das elektrochrome Material kann sich in der Haupterstreckungsebene des Substrats 101 über das gesamte Substrat 101 erstrecken, so dass sich die gesamte durch das Substrat 101 gebildete Fläche durch Regelung des elektrochromen Materials abdunkeln lässt. Alternativ hierzu kann das elektrochrome Material in einem oder mehreren Teilbereichen angeordnet sein, so dass das Substrat 101 entlang seiner Haupterstreckungsebene auch einen oder mehrere Teilbereiche aufweisen kann, die kein elektrochromes Material enthalten und beispielsweise unveränderlich transparent sind. In jedem Fall ist das elektrochrome Material derart angeordnet, dass sich die reflektierende Schicht 120 von einem Betrachter aus gesehen hinter dem elektrochrome Material befindet.

Weiterhin kann das Substrat 101 und damit auch die Spiegelvorrichtung fest oder flexibel oder auch beispielsweise konkav gewölbt für eine Vergrößerungswirkung sein.

Das organische optoelektronische Element 100 weist auf dem Substrat 101 Elektroden 102, 104 auf, zwischen denen ein organischer funktioneller Schichtenstapel 103 mit zumindest einer organischen funktionellen Schicht angeordnet ist.

Der organische funktionelle Schichtenstapel 103 zwischen den Elektrode 102, 104 weist eine organische funktionelle Schicht auf, die als organische Licht detektierende Schicht ausgebildet ist und die in einem ersten Betriebszustand der Spiegelvorrichtung durch das Substrat 101 Umgebungslicht detektieren kann, so dass das organische optoelektronische Element 100 im ersten Betriebszustand als organisches Licht detektierendes Element wirkt. Das organische optoelektronische Element 100 ist somit dazu eingerichtet, im ersten Betriebszustand bei Einstrahlung von Umgebungslicht dieses in ein elektrisch messbares Signal, beispielsweise in eine Fotospannung, in einen Fotostrom oder in einen lichtabhängigen elektrischen Widerstand, umzuwandeln. Hierzu kann das organische optoelektronische Element wie oben im allgemeinen Teil ausgeführt als organische Fotodiode, organischer Fotoleiter und/oder als organischer Fotowiderstand ausgebildet sein.

Bei Einstrahlung von Umgebungslicht, insbesondere von Umgebungslicht mit einer bestimmten Helligkeit wie beispielsweise von Autoscheinwerfern, kann im ersten Betriebszustand ein automatisches Abblenden der Spiegelvorrichtung möglich sein, indem das Signal des organischen optoelektronischen Elements 100 mittels einer geeigneten Regelungsschaltung direkt zur Steuerung des elektrochromen Materials des Substrats 101 verwendet wird.

Weiterhin ist im gezeigten Ausführungsbeispiel die zumindest eine organischen optoelektronische Schicht des organischen funktionellen Schichtenstapels 103 des organischen optoelektronischen Elements 100 zusätzlich als organische Licht emittierende Schicht ausgebildet, die in einem zweiten Betriebszustand der Spiegelvorrichtung Licht abstrahlen kann. Das organische optoelektronische Element 100 kann im zweiten Betriebszustand somit als organische Licht emittierende Diode (OLED) wirken und Licht durch das Substrat 101 abstrahlen. Hierzu kann der organische funktionelle Schichtenstapel 103 einen geeigneten Diodenschichtaufbau aufweisen, der durch unterschiedliche Polung, also durch Betrieb in Sperr- oder in Durchlassrichtung, Licht detektierend oder Licht emittierend betrieben werden kann. Durch Schalten in den ersten oder zweiten Betriebszustand kann die Spiegelvorrichtung somit wahlweise als abblendbare Spiegelvorrichtung oder als Beleuchtungsvorrichtung betrieben werden. Alternativ zum gezeigten Ausführungsbeispiel kann das organische optoelektronische Element 100 auch nur als organisches Licht detektierendes Element ausgebildet sein, so dass die gezeigte Spiegelvorrichtung in diesem Fall nur im ersten Betriebszustand ohne zusätzliche Beleuchtungsfunktion betrieben werden kann.

Die untere Elektrode 102, also die dem Substrat 101 zugewandt angeordnete Elektrode, ist transparent ausgebildet und weist beispielsweise ein transparentes leitendes Oxid auf. Transparente leitende Oxide ("transparent conductive oxide", TCO) sind transparente, leitende Materialien, in der Regel Metalloxide, wie beispielsweise Zinkoxid, Zinnoxid, Cadmiumoxid, Titanoxid, Indiumoxid und Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Alternativ oder zusätzlich kann die untere Elektrode 102 Graphen, Metalldrähte und/oder Metallmaschen aufweisen. Diese Materialien können insbesondere auch mit einer Schicht aus einem TCO-Material zur Bildung der Elektrode kombiniert werden und die Querleitfähigkeit der Elektrode erhöhen.

Weiterhin kann die transparente Elektrode 102 ein transparentes Metall aufweisen, also ein weiter unten genanntes für Elektroden geeignetes Metall mit einer Dicke, die ausreichend gering ist, so dass die Elektrode 102 für Licht zumindest teilweise durchlässig ist. Weiterhin kann die transparente Elektrode 102 beispielsweise metallische Netzstrukturen und/oder Graphen oder Kombinationen der genannten transparenten Materialien aufweisen.

Die weitere Elektrode 104 auf dem organischen funktionellen Schichtenstapel 103 ist reflektierend ausgebildet und weist ein Metall auf, das ausgewählt sein kann aus Aluminium, Barium, Indium, Silber, Gold, Magnesium, Kalzium und Lithium sowie Verbindungen, Kombinationen und Legierungen damit. Insbesondere kann die Elektrode 104 Graphit, Graphen, Ag, Al oder Legierungen oder Schichtstapel mit diesen aufweisen, beispielsweise Ag/Mg, Ag/Ca, Mg/Al oder auch Mo/Al/Mo oder Cr/Al/Cr. Alternativ oder zusätzlich kann die Elektrode 104 auch ein oben genanntes TCO-Material oder einen Schichtenstapel mit zumindest einem TCO und zumindest einem Metall aufweisen.

Im gezeigten Ausführungsbeispiel weist die reflektierende Schicht 120 der Spiegelvorrichtung die Elektrode 104 des organischen optoelektronischen Elements 100 auf. Insbesondere wird im gezeigten Ausführungsbeispiel die reflektierende Schicht 120 durch die Elektrode 104 gebildet.

Zur elektrischen Kontaktierung der Elektroden 102 und 104 können, wie in Figur 1 gezeigt ist, Elektrodenanschlussstücke 105 vorgesehen sein, die unter der weiter unten beschriebenen Verkapselung 107 hindurch von den Elektroden 102, 104 nach außen reichen. Die als elektrische Kontaktzuführungen ausgebildeten Elektrodenanschlussstücke 105 können transparent oder nicht-transparent ausgebildet sein und beispielsweise ein TCO und/oder ein Metall aufweisen oder daraus sein. Beispielsweise können die Elektrodenanschlusstücke 105 durch eine Metallschicht oder einen Metallschichtstapel gebildet sein, beispielsweise Mo/Al/Mo, Cr/Al/Cr oder Al.

Die Elektroden 102, 104 sind bevorzugt großflächig und zusammenhängend ausgebildet, so dass das organische optoelektronische Element 100 als großflächiges Sensorelement und als großflächige Leuchtquelle, insbesondere als Flächenlichtquelle, ausgeformt ist. "Großflächig" kann dabei bedeuten, dass das organische optoelektronische Element 100 möglichst die gesamte spiegelnde Fläche der Spiegelvorrichtung bildet. Alternativ hierzu kann auch noch zusätzlich eine Spiegelfläche mit einer Spiegelschicht lateral benachbart zum organischen optoelektronischen Element 100 vorgesehen sein, die die spiegelnde Fläche der Spiegelvorrichtung vergrößern kann. Weiterhin kann es auch möglich sein, dass beispielsweise die untere Elektrode 102 des organischen optoelektronischen Elements 100 strukturiert ausgebildet ist, wodurch im zweiten Betriebszustand ein strukturierter Leuchteindruck erweckt werden kann.

Der organische funktionelle Schichtenstapel 103 kann zusätzlich zur zumindest einen organischen optoelektronischen Schicht, die je nach Beschaltung Licht emittierend oder Licht detektierend wirkt, weitere organische Schichten aufweisen, beispielsweise eine oder mehrere ausgewählt aus einer Lochinjektionsschicht, einer Lochtransportschicht, einer Elektronenblockierschicht, einer Löcherblockierschicht, einer Elektronentransportschicht, einer Elektroneninjektionsschicht und einer ladungserzeugenden Schicht ("charge generation layer", CGL), die geeignet sind, Löcher bzw. Elektronen zur organischen optoelektronischen Schicht hin- oder abzuleiten bzw. den jeweiligen Transport zu blockieren. Die Schichten des organischen funktionellen Schichtstapels 103 können organische Polymere, organische Oligomere, organische Monomere, organische kleine, nicht-polymere Moleküle ("small molecules") oder Kombinationen daraus aufweisen. Geeignete Materialien und Schichtkombinationen für Schichtaufbauten für organische optoelektronische Elemente, insbesondere für organische Licht detektierende und Licht emittierende Elemente, sind dem Fachmann bekannt und werden daher hier nicht weiter ausgeführt.

Weiterhin können, wie in Figur 1 gezeigt ist, Isolatorschichten 106 vorhanden sein, beispielsweise mit oder aus Polyimid, die beispielsweise die Elektroden 102, 104 gegeneinander elektrisch isolieren können. Je nach Ausgestaltung der einzelnen Schichten des organischen optoelektronischen Elements 100 müssen Isolatorschichten 106 auch nicht zwingend erforderlich sein und können nicht vorhanden sein, etwa bei entsprechenden Maskenprozessen zur Aufbringung der Schichten.

Vom Substrat aus gesehen ist über dem organischen funktionellen Schichtenstapel 103 und den Elektroden 102, 104 eine Verkapselung 107 zum Schutz des organischen funktionelle Schichtenstapels 103 und der Elektroden 102, 104 angeordnet. Die Verkapselung 107 ist dabei besonders bevorzugt als Dünnfilmverkapselung ausgeführt.

Unter einer als Dünnfilmverkapselung ausgebildeten Verkapselung wird vorliegend eine Vorrichtung verstanden, die dazu geeignet ist, eine Barriere gegenüber atmosphärischen Stoffen, insbesondere gegenüber Feuchtigkeit und Sauerstoff und/oder gegenüber weiteren schädigenden Substanzen wie etwa korrosiven Gasen, beispielsweise Schwefelwasserstoff, zu bilden. Mit anderen Worten ist die Dünnfilmverkapselung derart ausgebildet, dass sie von atmosphärischen Stoffen höchstens zu sehr geringen Anteilen durchdrungen werden kann. Diese Barrierewirkung wird bei der Dünnfilmverkapselung im Wesentlichen durch als dünne Schichten ausgeführte Barriereschichten und/oder Passivierungsschichten erzeugt, die Teil der Verkapselung sind. Die Schichten der Verkapselung weisen in der Regel eine Dicke von kleiner oder gleich einigen 100 nm auf.

Insbesondere kann die Dünnfilmverkapselung dünne Schichten aufweisen oder aus diesen bestehen, die für die Barrierewirkung der Verkapselung verantwortlich sind. Die dünnen Schichten können beispielsweise mittels eines Atomlagenabscheideverfahrens ("atomic layer deposition", ALD) oder Moleküllagenabscheideverfahrens ("molecular layer deposition", MLD) aufgebracht werden. Geeignete Materialien für die Schichten der Verkapselungsanordnung sind beispielsweise Aluminiumoxid, Zinkoxid, Zirkoniumoxid, Titanoxid, Hafniumoxid, Lanthanoxid, Tantaloxid. Bevorzugt weist die Verkapselung eine Schichtenfolge mit einer Mehrzahl der dünnen Schichten auf, die jeweils eine Dicke zwischen einer Atomlage und einigen 100 nm aufweisen.

Alternativ oder zusätzlich zu mittels ALD oder MLD hergestellten dünnen Schichten kann die Verkapselung zumindest eine oder eine Mehrzahl weiterer Schichten, also insbesondere Barriereschichten und/oder Passivierungsschichten, aufweisen, die durch thermisches Aufdampfen oder mittels eines plasmagestützten Prozesses, etwa Sputtern, chemischer Gasphasenabscheidung ("chemical vapor deposition", CVD) oder plasmaunterstützter chemischer Gasphasenabscheidung ("plasma-enhanced chemical vapor deposition", PECVD), abgeschieden werden. Geeignete Materialien dafür können die vorab genannten Materialien sowie Siliziumnitrid, Siliziumoxid, Siliziumoxinitrid, Indiumzinnoxid, Indiumzinkoxid, Aluminium-dotiertes Zinkoxid, Aluminiumoxid sowie Mischungen und Legierungen der genannten Materialien sein. Die eine oder die mehreren weiteren Schichten können beispielsweise jeweils eine Dicke zwischen 1 nm und 5 µm und bevorzugt zwischen 1 nm und 400 nm aufweisen, wobei die Grenzen eingeschlossen sind.

Alternativ oder zusätzlich zu einer Dünnfilmverkapselung kann die Verkapselung 107 auch einen Glasdeckel aufweisen, der beispielsweise in Form eines Glassubstrats mit einer Kavität mittels einer Klebstoffschicht auf dem Substrat 101 aufgeklebt wird. In die Kavität kann weiterhin ein Feuchtigkeit absorbierender Stoff (Getter), beispielsweise aus Zeolith, eingeklebt sein, um Feuchtigkeit, Sauerstoff oder andere schädigenden Gase, die durch den Klebstoff eindringen können, zu binden. Weiterhin kann auch die Klebstoffschicht zur Befestigung des Deckels auf dem Substrat selbst absorbierend für schädigende Substanzen sein und/oder es können Klebstoffschichtstrukturen vorhanden sein.

Weiterhin kann vom Substrat 101 aus gesehen auf der Verkapselung 107, wie in Figur 1 gezeigt ist, eine mittels einer Klebstoffschicht 108 aufgeklebte Abdeckung 109 angeordnet sein. Die Abdeckung 109, die im Hinblick auf ihre Anordnung im Vergleich zum Substrat 101 auch als "Superstrat" bezeichnet werden kann, kann beispielsweise durch eine Glasschicht oder Glasplatte oder auch einen Kunststoff, Graphit, ein Metall oder eine Kombination oder ein Laminat der genannten Materialien gebildet sein und insbesondere in Verbindung mit einer als Dünnfilmverkapselung ausgebildeten Verkapselung 107 als mechanischer Schutz, insbesondere als Katzschutz, dienen, ohne dass die Abdeckung 109 selbst verkapselnd wirken muss. Alternativ oder zusätzlich kann auf der Verkapselung 107 auch ein Schutzlack, beispielsweise in Form eines Sprühlacks, aufgebracht sein.

Die im Folgenden gezeigten Ausführungsbeispiele von abdunkelbaren Spiegelvorrichtungen weisen jeweils ein organisches optoelektronisches Element 100 auf, das gemäß dem Ausführungsbeispiel der Figur 1 ausgebildet sein oder das Modifikationen oder Variationen zu diesem aufweisen kann. Die Kontaktelemente 111 zur elektrischen Kontaktierung und Regelung des elektrochromen Materials des Substrats 101 sind in den folgenden Figuren der Übersichtlichkeit halber nicht gezeigt.

In Figur 2A ist eine abdunkelbare Spiegelvorrichtung gemäß einem weiteren Ausführungsbeispiel gezeigt, das neben einem organischen optoelektronischen Element 100, das rein beispielhaft nur als organisches Licht detektierendes Element zur Steuerung der Transparenz des Substrats 101 ausgebildet ist, ein organisches Licht emittierendes Element 200 aufweist. Das organische Licht emittierende Element 200 ist zusammen mit dem organischen optoelektronischen Element 100 auf dem Substrat 101 angeordnet, sodass das Substrat 101 ein gemeinsames Substrat für das organische optoelektronische Element 100 und das organische Licht emittierende Element 200 bildet. Insbesondere sind das organische optoelektronische Element 100 und das organische Licht emittierende Element 200 auf derselben Seite des gemeinsamen Substrats 101 in lateral benachbarten Flächenbereichen angeordnet.

Im gezeigten Ausführungsbeispiel ist das organische Licht emittierende Element 200 als organische Licht emittierende Diode mit einem organische funktionellen Schichtenstapel mit zumindest einer organischen funktionellen Schicht zwischen Elektroden 202, 204 ausgebildet. Insbesondere weist das organische Licht emittierende Element 200 im gezeigten Ausführungsbeispiel im Hinblick auf die Elektroden 202, 204 und den organischen funktionellen Schichtenstapel 203 denselben Aufbau wie das organische optoelektronische Element 100 im Hinblick auf die Elektroden 102, 104 und den organischen funktionellen Schichtenstapel 103 auf und kann invers zum organischen optoelektronischen Element 100, also mit entgegengesetzter elektrischer Polung, angeschlossen und betrieben werden. Dadurch kann die Fertigung der gezeigten Spiegelvorrichtung im Vergleich zur Spiegelvorrichtung des Ausführungsbeispiels der Figur 1 keine oder nur geringe Mehrkosten verursachen. Alternativ hierzu kann das organische Licht emittierende Element 200 im Vergleich zum organischen optoelektronischen Element 100 andere Materialien und/oder andere Schichtaufbauten im Hinblick auf die Elektroden 202, 204 und/oder den organischen funktionellen Schichtenstapel 203 aufweisen.

Die Spiegelvorrichtung weist weiterhin eine Verkapselung 107 auf, die als Dünnfilmverkapselung ausgebildet ist und die eine gemeinsame Verkapselung für das organische optoelektronische Element 100 und das organische Licht emittierende Element 200 bildet. Mit anderen Worten erstreckt sich die Verkapselung 107 großflächig und zusammenhängend über die funktionellen Schichten des organischen optoelektronischen Elements 100 und des organischen Licht emittierenden Elements 200. Auf der gemeinsamen Verkapselung 107 ist eine gemeinsame Abdeckung 109 mittels einer Klebeschicht 108 befestigt.

Weiterhin sind Elektrodenanschlusstücke 205 vorhanden, die der elektrischen Kontaktierung der Elektroden 202, 204 dienen und die wie die Elektrodenanschlusstücke 105 des organischen optoelektronischen Elements 100 ausgebildet sein können. Die Elektrodenanschlussstücke 105, 205 erstrecken sich von den Elementen 100, 200 aus der Verkapselung 107 heraus, sodass die Elemente 100, 200 von außen kontaktierbar sind. Die Elektroden 202, 204 sind durch Isolatorschichten 206 voneinander elektrisch isoliert.

Zwischen dem organischen optoelektronischen Element 100 und dem organischen Licht emittierenden Element 200 ist auf dem Substrat 101 eine elektrische Isolatorschicht 112 angeordnet, die von der gemeinsamen Verkapselung 107 bedeckt ist. Die elektrische Isolatorschicht 112, die beispielsweise Polyimid oder ein anderes elektrisch isolierendes Material aufweisen oder daraus sein kann, dient der elektrischen Isolation des organischen Licht emittierenden Elements 200 vom organischen optoelektronischen Element 100, sodass die Elektrodenanschlussstücke 105, 205 der Elemente 100, 200 auch in einem geringen Abstand voneinander auf dem gemeinsamen Substrat 101 angeordnet werden können, ohne dass es zu einem elektrischen Übersprechen zwischen den Elementen 100, 200 kommt.

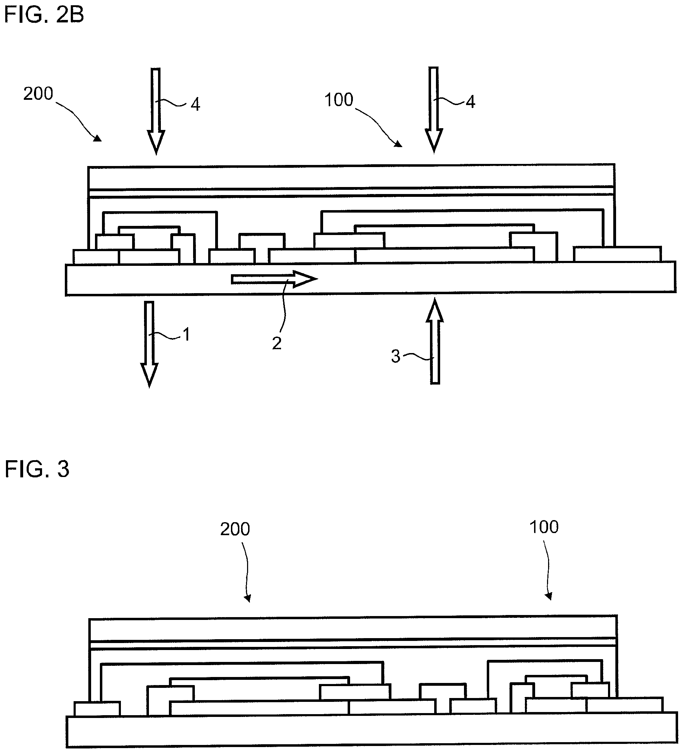

In Figur 2B sind für die Spiegelvorrichtung der Figur 2A die Lichtverhältnisse angedeutet. In Figur 2B wie auch in den nachfolgenden Figuren sind die Bezugszeichen der einzelnen Schichten und Elemente der jeweils gezeigten Spiegelvorrichtung der Übersichtlichkeit halber hauptsächlich nur im Hinblick auf Unterschiede zu den bisher beschriebenen Ausführungsbeispielen eingezeichnet.

Das organische Licht emittierende Element 200 der Figuren 2A und 2B strahlt im Betrieb Licht 1 durch das Substrat 101 ab, so dass insbesondere in einem zweiten Betriebszustand der Spiegelvorrichtung diese zur Beleuchtung eingesetzt werden kann. Die Substratseite der Spiegelvorrichtung bildet somit die Abstrahlseite. Durch das transparente Substrat 101 kann auch ein Teil des vom organischen Licht emittierenden Element 200 erzeugten Lichts aufgrund von Streuung und Wellenleitungseffekten zum organischen optoelektronischen Element 100 geleitet werden, wie durch das Bezugszeichen 2 angedeutet ist. Weiterhin kann je nach Ausbildung der Elektroden und Isolatorschichten möglicherweise auch Licht durch die gemeinsame Verkapselung vom organischen Licht emittierenden Element 200 zum organischen optoelektronischen Element 100 gelangen. Durch eine gezielte Anpassung des Abstands zwischen dem organischen Licht emittierenden Element 200 und dem organischen optoelektronischen Element 100 und hierbei insbesondere im Hinblick auf eine Absorption im gemeinsamen Substrat, durch eine geeignete Materialwahl im Hinblick auf die Elektroden, die Isolatorschichten und die Verkapselung, beispielsweise im Hinblick auf einen geeigneten Brechungsindex zur Vermeidung von Totalreflexion im Substrat oder der Abdeckung, sowie durch geeignete, zumindest stellenweise nicht-transparente Materialien, kann das intern vom organischen Licht emittierenden Element 200 zum organischen optoelektronischen Element 100 geleitete Licht 2 verringert oder gänzlich unterdrückt werden.

Umgebungslicht kann auf der Substratseite, angedeutet durch die Bezugszeichen 3, und/oder auf der dem Substrat gegenüber liegenden Seite, also auf der Seite der Abdeckung, angedeutet durch die Bezugszeichen 4, eingestrahlt werden. Das Umgebungslicht 3, 4 kann beispielsweise Licht von natürlichen oder künstlichen Lichtquellen sein. Im Hinblick auf die Verwendung der Spiegelvorrichtung als Rückspiegel in einem Kraftfahrzeug kann das Umgebungslicht 4 insbesondere auch das allgemeine Umgebungslicht sein, das eine Messung der allgemeinen, beispielsweise tageszeitabhängigen Helligkeit, ermöglicht, während das Umgebungslicht 3 auch Scheinwerferlicht des nachfolgenden Verkehrs aufweisen kann, der ohne eine Abdunkelung durch das elektrochrome Material des Substrats 101 zu einer Blendung eines Betrachters der Spiegelvorrichtung führen kann.

In den folgenden Ausführungsbeispielen sind weitere Variationen und Modifikationen der abdunkelbaren Spiegelvorrichtung gezeigt, die unter anderem Variationsmöglichkeiten im Aufbau und zur Lichtdetektion aufweisen. Variiert werden können beispielsweise die Art der organischen optoelektronischen, Licht detektierenden und/oder Licht emittierenden Elemente im Hinblick auf den Aufbau und die Funktionsweise und/oder die elektrische Beschaltung, die Anzahl der Elemente, die Lage eines oder mehrerer organischer Licht detektierender oder optoelektronischer Elemente in Bezug auf die Leuchtfläche eines organischen Licht emittierenden Elements, eines Spiegels oder anderer Elemente, und/oder die Detektionsfläche eines organischen Licht detektierenden oder optoelektronischen Elements beispielsweise in Bezug auf eine Anpassung an das Umfeld in Geometrie, Stapel und/oder Beschaltung. Weiterhin können mehrere organische optoelektronische, Licht detektierende und/oder Licht emittierende Elemente zur Detektion von Umgebungslicht auf verschiedenen Seiten, und/oder zur Variation der Lichtabstrahlung vorgesehen sein. Darüber hinaus können eine zusätzliche Spiegelschicht oder zusätzliche elektrochrome Gläser, Folien und/oder Schichten vorgesehen sein.

In Figur 3 ist beispielsweise ein Ausführungsbeispiel für eine Spiegelvorrichtung gezeigt, die im Vergleich zum Ausführungsbeispiel der Figur 1 ein organisches optoelektronisches Element 100 und ein organisches Licht emittierendes Element 200 aufweist. Im Vergleich zum Ausführungsbeispiel der Figuren 2A und 2B weist das organische Licht emittierende Element 200 in Figur 3 eine größere Fläche als das organische optoelektronische Element 100 auf, so dass die Leuchtfläche für den Betrieb im zweiten Betriebszustand deutlich größer ist als die Sensorfläche für den Betrieb im ersten Betriebszustand. Insbesondere kann die reflektierende Schicht der Spiegelvorrichtung durch die reflektierende Elektrode des organischen Licht emittierenden Elements 200 gebildet werden oder diese zumindest aufweisen.

Beispielsweise kann bei einer derartigen Ausbildung das organische optoelektronische Element 100 auch lateral versetzt zum elektrochromen Material des Substrats sein, so dass das organische optoelektronische Element 100 das durch das Substrat eingestrahlte Umgebungslicht unabhängig von der Transparenz des Substrats messen kann.

In den Ausführungsbeispielen der Figuren 2A bis 3 kann das organische Licht emittierende Element 100 auch gleichzeitig mit dem organischen optoelektronischen Element 100 betrieben werden.

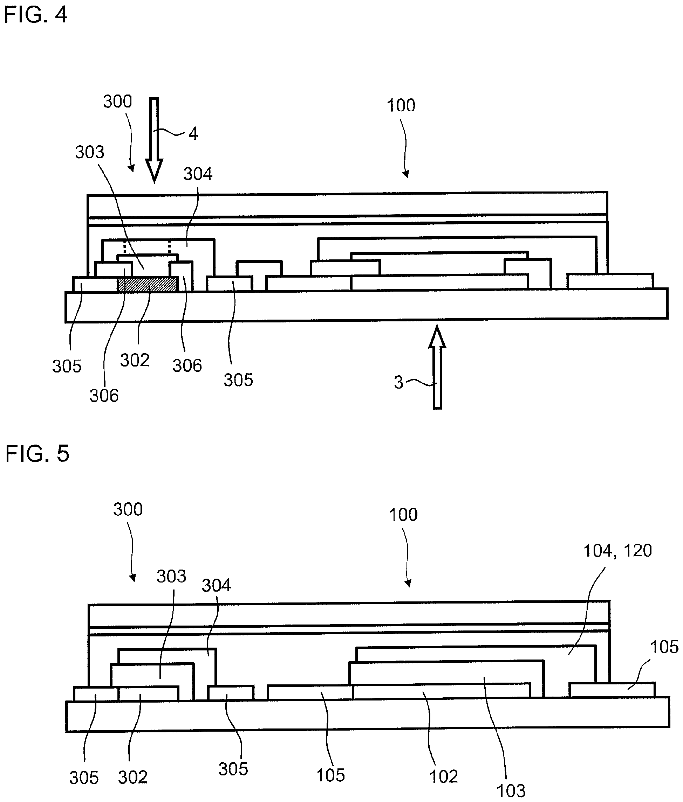

In Figur 4 ist ein weiteres Ausführungsbeispiel für eine Spiegelvorrichtung gezeigt, die im Vergleich zu den vorherigen Ausführungsbeispielen zusätzlich zum organischen optoelektronischen Element 100, das wie im Ausführungsbeispiel der Figur 1 Licht detektierend und Licht emittierend ausgebildet ist, ein organisches Licht detektierendes Element 300 aufweist.

Im gezeigten Ausführungsbeispiel ist das organische Licht detektierende Element 300 als organische Fotodiode ausgebildet und einsetzbar. Das organische Licht detektierende Element 300 weist einen organischen funktionellen Schichtenstapel 303 zwischen zwei Elektroden 302, 304 auf, wobei der organische funktionelle Schichtenstapel 303 zumindest eine organische Licht detektierende Schicht aufweist. Im gezeigten Ausführungsbeispiel ist die zumindest eine organische Licht detektierende Schicht als pn-Übergang zur Erzeugung von Ladungsträgern ausgebildet.

Insbesondere kann das organische Licht detektierende Element 300 im gezeigten Ausführungsbeispiel beispielsweise im Hinblick auf den organischen funktionellen Schichtenstapel 303 denselben Aufbau wie das organische optoelektronische Element 100 im Hinblick auf den organischen funktionellen Schichtenstapel 103 aufweisen. Dadurch kann die Fertigung der gezeigten Spiegelvorrichtung im Vergleich zu einer Spiegelvorrichtung mit nur einem organischen optoelektronischen Element wie in Figur 1 gezeigt keine oder nur geringe Mehrkosten verursachen. Alternativ hierzu kann das organische Licht detektierende Element 300 im Vergleich zum organischen Licht emittierenden Element 100 andere Materialien und/oder andere Schichtaufbauten im Hinblick auf den organischen funktionellen Schichtenstapel 303 aufweisen.

Weiterhin sind Elektrodenanschlusstücke 305 vorhanden, die der elektrischen Kontaktierung der Elektroden 302, 304 dienen und die wie die Elektrodenanschlusstücke 105 des organischen optoelektronischen Elements 100 ausgebildet sein können. Die Elektrodenanschlussstücke 105, 305 erstrecken sich von den Elementen 100, 300 aus der Verkapselung 107 heraus, sodass die Elemente 100, 300 von außen kontaktierbar sind. Die Elektroden 302, 304 sind durch Isolatorschichten 306 voneinander elektrisch isoliert.

Im Gegensatz zum organischen optoelektronischen Element 100 ist beim organischen Licht detektierenden Element 300 die untere Elektrode 302, also die Elektrode, die auf der Substratseite angeordnet ist, nicht-transparent und beispielsweise reflektierend ausgebildet ist, wie durch die Schraffierung angedeutet ist, während die oben liegende, auf der dem Substrat gegenüber liegenden Seite angeordnete Elektrode 304 transparent oder zumindest in Teilbereichen lichtdurchlässig ausgebildet ist. Die obere Elektrode 304 kann beispielsweise ein transparentes Material wie etwa ein TCO aufweisen. Alternativ oder zusätzlich kann es auch möglich sein, dass die obere Elektrode 304 als Ringkontakt ausgebildet ist und beispielsweise vom Substrat aus gesehen eine Öffnung über dem organischen funktionellen Schichtenstapel 303 des organischen Licht detektierenden Elements 300 aufweist, wie durch die gestrichelten Linien angedeutet ist. Eine solche Öffnung kann in lateraler Richtung gänzlich von Elektrodenmaterial umschlossen sein, sodass die Elektrode 304 als vollständiger Ring ausgebildet sein kann. Weiterhin ist es auch möglich, dass eine als Ringkontakt ausgebildete Elektrode 304 in lateraler Richtung die Öffnung nur in einem Teilbereich umschließt und somit beispielsweise U-förmig ausgebildet ist. Darüber hinaus kann die Elektrode 304 alternativ oder zusätzlich ein anderes oben genanntes transparentes Elektrodenmaterial aufweisen.

Durch die transparente obere Elektrode 304 und die nicht-transparente untere Elektrode 302 ist das organische Licht detektierende Element 300 in diesem Ausführungsbeispiel dazu eingerichtet, Umgebungslicht 4 zu detektieren, das von der dem Substrat gegenüber liegenden Seite auf das organische optoelektronische Bauelement eingestrahlt wird, während das organische optoelektronische Element 100 Umgebungslicht 3 von der Substratseite detektiert. Das organische Licht detektierende Element 300 kann somit einen Referenzsensor bilden, der die allgemeine Helligkeit misst. In Abhängigkeit dieser Messung, insbesondere bei einer festgestellten geringen Umgebungshelligkeit wie beispielsweise in der Nacht kann das organische optoelektronische Element 100 im ersten Betriebszustand betrieben werden. Unabhängig von der Messung des organischen Licht detektierenden Elements 300 kann das organische optoelektronische Element 100 im zweiten Betriebszustand beispielsweise im Falle einer Spiegelvorrichtung für ein Kraftfahrzeug im stehenden Fahrzeug als Lichtquelle betrieben werden.

Alternativ zum gezeigten Ausführungsbeispiel kann das organische Licht detektierende Element 300 auch dazu eingerichtet sein, Umgebungslicht durch das Substrat oder beidseitig zu detektieren.

In Figur 5 ist ein weiteres Ausführungsbeispiel für eine Spiegelvorrichtung gezeigt, bei der im Vergleich zu den bisher gezeigten Ausführungsbeispielen keine Isolatorschichten 106, 306, 112 vorhanden sind. Die im gezeigten Ausführungsbeispiel gezeigten Elektroden 102, 104 und 302, 304 sind beispielsweise durch geeignete Maskenprozesse bei der Herstellung derart ausgebildet, dass sich auch ohne Isolatorschichten 106, 306 und die damit partiell offenen organischen Schichten keine Kurzschlüsse ergeben. Ein entsprechender Aufbau ist auch im Falle eines organischen Licht emittierenden Elements 200 neben dem organischen optoelektronischen Element 100 möglich.

Wie in den folgenden Figuren gezeigt ist, können auch mehrere organische optoelektronische, Licht detektierende und/oder Licht emittierende Elemente miteinander kombiniert sein.

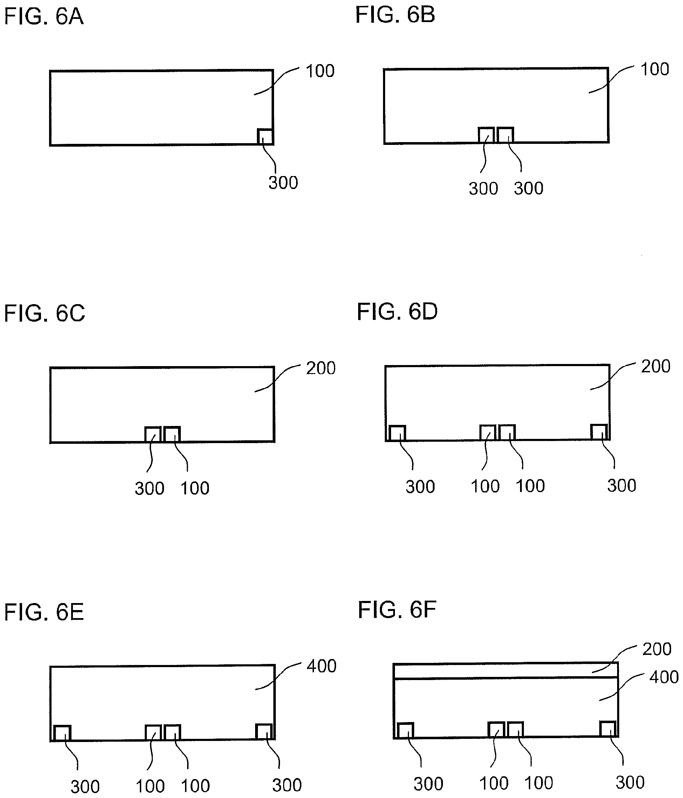

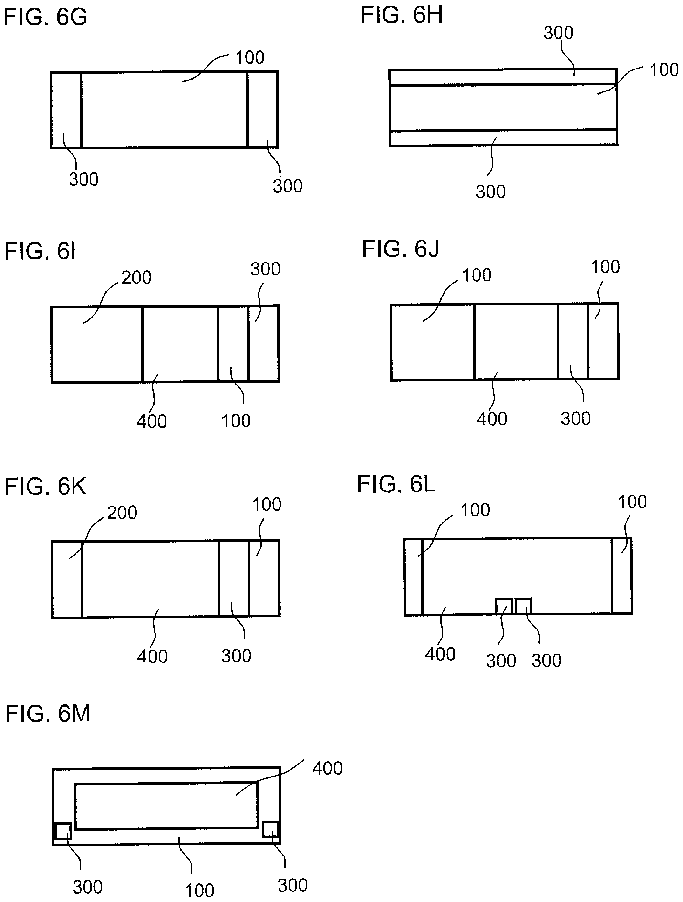

In den Figuren 6A bis 6M sind in Aufsichten auf die Betrachtungsseite, also die Substratseite, der Spiegelvorrichtung Variationsmöglichkeiten für die Anordnung, die Anzahl und die Lage von organischen optoelektronischen Elementen 100, organischen Licht emittierenden Elementen 200 und organischen Licht detektierenden Elementen 300 gemäß mehreren Ausführungsbeispielen gezeigt, wobei der Übersichtlichkeit halber lediglich die Positionen der Elemente ohne genaue Darstellung der Leuchtfläche und der Kontaktzuführungen angedeutet sind. Die organischen Licht detektierenden Elemente 300 sind rein beispielhaft zur Detektion von Umgebungslicht auf der dem Substrat abgewandten Seite der Spiegelvorrichtung vorgesehen, während die organischen optoelektronischen Elemente 100 rein beispielhaft zur Detektion von Umgebungslicht durch das Substrat in einem ersten Betriebszustand und zur Abstrahlung von Licht durch das Substrat in einem zweiten Betriebszustand vorgesehen sind.

Wie in den Figuren 6A und 6B gezeigt ist, kann beispielsweise ein organisches optoelektronisches Element 100 großflächig vorgesehen sein und insbesondere auch die reflektierende Schicht der Spiegelvorrichtung bereitstellen, während ein oder mehrere organische Licht detektierende Elemente 300 in Rand- oder Eckenbereichen vorgesehen sind.

Alternativ hierzu kann beispielsweise anstelle des großflächigen organischen optoelektronischen Elements 100 ein großflächiges organisches Licht emittierendes Element 200 vorgesehen sein, das eine reflektierende Elektrode aufweist, die zumindest einen Teil der reflektierenden Schicht der Spiegelvorrichtung bildet, während eines oder mehrere organische optoelektronische Elemente 100 sowie weiterhin auch eines oder mehrere organische Licht detektierende Elemente 300 vorgesehen sein können, wie in den Figuren 6C und 6D gezeigt ist.

Zumindest in Teilbereichen der Spiegelvorrichtung kann eine Spiegelfläche 400 vorgesehen sein, die beispielsweise lateral neben den Elementen 100, 200, 300 auf dem Substrat angeordnet sein kann, wie in den Figuren 6E und 6F gezeigt ist.

In den Figuren 6G bis 6M sind weitere Anordnungsmöglichkeiten der Elemente 100, 200, 300 und der Spiegelfläche 400 gezeigt, wobei diese beispielsweise auch streifen- oder rahmenförmig ausgebildet sein können.

Zusätzlich zu den geigten Ausführungsbeispielen sind Kombinationen und Variationen der gezeigten Anordnungen der gezeigten Elemente 100, 200, 300 und der Spiegelfläche 400 möglich. Insbesondere sind beliebige Kombinationen der Spiegelfläche 400, der Leuchtflächen von organischen optoelektronischen und/oder Licht emittierenden Elementen 100, 200 und der Detektion von Umgebungslicht auf der Substratseite und der gegenüber liegenden Seite möglich. Die in den gezeigten Ausführungsbeispielen gezeigten organischen Licht emittierenden Elemente 200 können auch als organische optoelektronische Elemente und/oder als organische Licht detektierende Elemente ausgeführt sein.

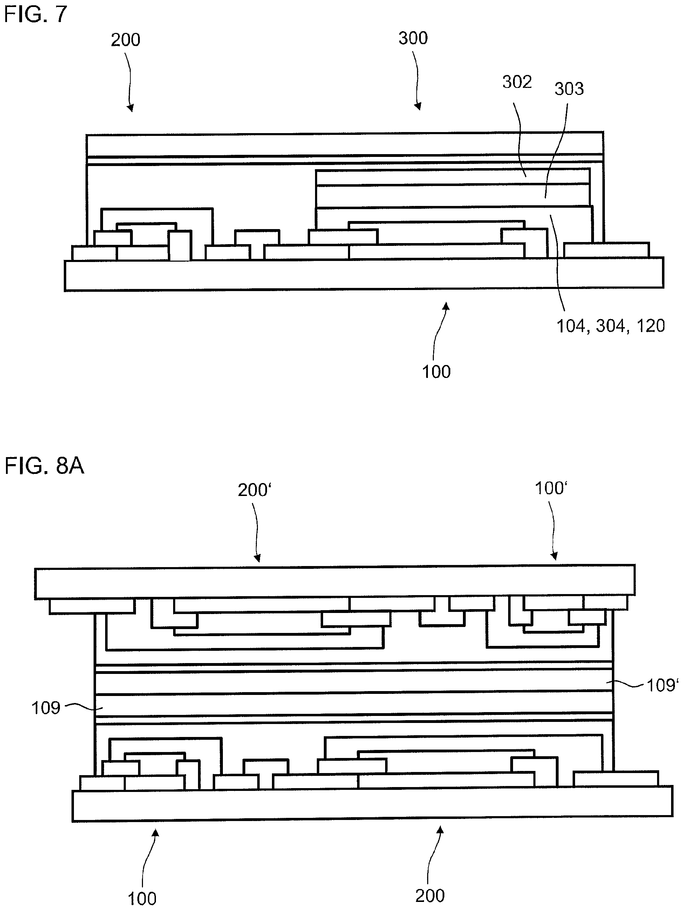

Weiterhin ist auch ein doppelseitiger Schichtaufbau, wie in den Ausführungsbeispielen der Figuren 7 bis 8B gezeigt ist, möglich.

In Figur 7 ist eine Spiegelvorrichtung gezeigt, die im Vergleich zum Ausführungsbeispiel der Figuren 2A und 2B vom Substrat aus gesehen auf dem organischen optoelektronischen Element 100 ein organisches Licht detektierendes Element 300 zur Detektion von Umgebungslicht aufweist, das von der dem Substrat gegenüber liegenden Seite auf die Spiegelvorrichtung eingestrahlt wird.

Das organische Licht detektierende Element 300 weist wie in Verbindung mit den vorherigen Ausführungsbeispielen beschrieben zwischen zwei Elektroden 302, 304 einen organischen funktionellen Schichtenstapel 303 mit zumindest einer organischen Licht detektierenden Schicht auf, wobei eine der Elektroden 304, die im gezeigten Ausführungsbeispiel gleichzeitig auch die reflektierende Schicht 120 der Spiegelvorrichtung bildet, durch die Elektrode 104 des organischen optoelektronischen Elements 100 gebildet wird. Mit anderen Worten weisen das organische optoelektronische Element 100 und das darüber angeordnete organische Licht detektierende Element eine gemeinsame Elektrode 104, 304 auf. Die obere Elektrode 302 ist transparent oder zumindest semitransparent ausgebildet. Die Elektrodenanschlussstücke für die Elektrode 302 ragen aus der Zeichnungsebene heraus und sind daher nicht gezeigt.

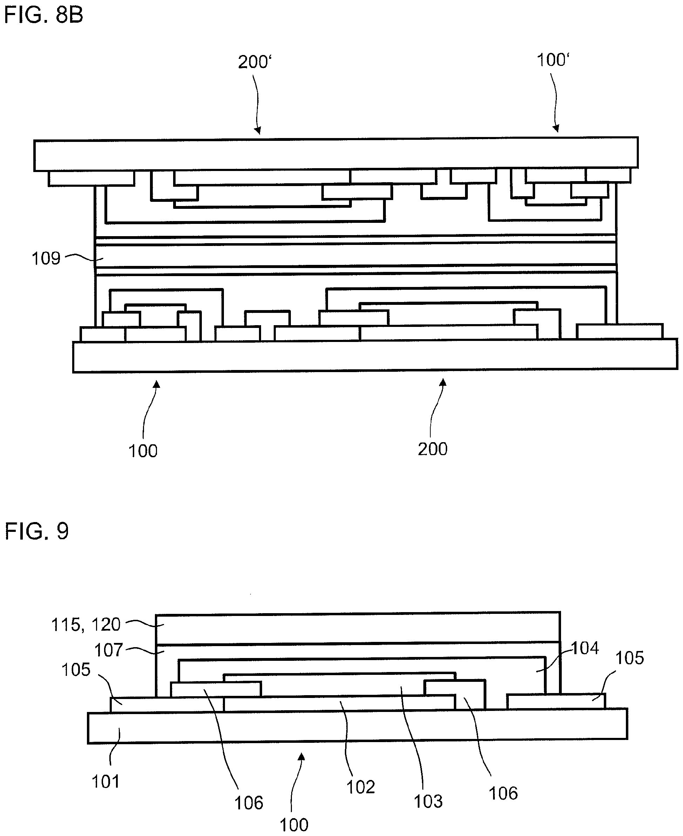

In den Figuren 8A und 8B sind Spiegelvorrichtungen gezeigt, die rein beispielhaft durch eine Verdopplung der Elemente gemäß dem Ausführungsbeispiel der Figur 3 gebildet werden, die voneinander abgewandt aufeinander aufgebracht sind, so dass ein abdunkelbarer Doppelspiegel, also eine beidseitig spiegelnde Spiegelvorrichtung, entsteht, wobei beide Seiten durch ein jeweiliges Substrat mit elektrochromem Material abdunkelbar sind. Insbesondere weisen die Spiegelvorrichtungen der Ausführungsbeispiele der Figuren 8A und 8B auf jeder Seite rein beispielhaft ein organische optoelektronisches Element 100, 100' und ein großflächiges organischen Licht emittierendes Element 200, 200' auf. Im Unterschied zum Ausführungsbeispiel der Figur 8A, bei dem die aufeinander aufgebrachten Elemente mit den jeweiligen Abdeckungen 109, 109' aufeinander angeordnet sind, weist das Ausführungsbeispiel der Figur 8B nur eine Abdeckung 109 als verbindendes Element auf.

In Figur 9 ist ein weiteres Ausführungsbeispiel für eine Spiegelvorrichtung gezeigt, die im Vergleich zu den vorherigen Ausführungsbeispielen ein organisches optoelektronisches Element 100 mit einer dem Substrat abgewandten transparenten oder bereichsweise lichtdurchlässig ausgebildeten Elektrode 104 aufweist. Weiterhin weist die Spiegelvorrichtung eine Spiegelschicht 115 mit regelbarer Reflektivität auf einer dem Substrat gegenüber liegenden Seite des organischen optoelektronischen Elements auf. Die reflektierende Schicht 120 der Spiegelvorrichtung wird zumindest teilweise durch die Spiegelschicht 115 mit der regelbaren Reflektivität gebildet.

Insbesondere weist die Spiegelschicht 115 mit der regelbaren Reflektivität auch eine regelbare Transparenz auf, so dass die Spiegelschicht 115 wahlweise reflektierend oder transparent geschaltet werden kann. Beispielsweise kann die Spiegelschicht 115 ein elektrochromes Material und/oder ein Flüssigkristallmaterial aufweisen, dessen Reflektivität und/oder Transmissivität beispielsweise von einer angelegten Spannung abhängen kann. Alternativ zu einer durchgehenden Schicht kann die Spiegelschicht 115 auch nur partiell vorhanden sein oder nur partiell im Hinblick auf ihre Reflektivität und Transmissivität schaltbar sein.

Die Spiegelschicht 115 mit der regelbaren Reflektivität und der regelbaren Transparenz ist insbesondere dazu vorgesehen und eingerichtet, die dem Substrat gegenüber liegende Seite der Spiegelvorrichtung in gewünschten Messintervallen zumindest teilweise transparent zu schalten, während derer das organischen optoelektronische Element 100 auch Umgebungslicht auf der dem Substrat abgewandten Seite der Spiegelvorrichtung detektieren kann. Eine solche Messung kann wie oben beschrieben beispielsweise als Referenzmessung geeignet sein, mit der die allgemeine Helligkeit, beispielsweise also das Tageslicht, festgestellt werden kann, so dass die Spiegelvorrichtung beispielsweise nur dann betrieben wird, wenn die allgemeine Helligkeit einen gewissen Wert unterschreitet, also beispielsweise während der Nacht oder in einer dunklen Umgebung.

Durch schnelles Schalten, also insbesondere schneller als die Wahrnehmung des menschlichen Auges, beispielsweise mit weniger als 3 ms Schaltzeit, kann ein asynchrones Detektieren von Umgebungslicht auf den beiden Seiten mit einer kurzzeitigen Detektion des Umgebungslichts auf der dem Substrat abgewandten Seite der Spiegelvorrichtung erreicht werden. Das auf der dem Substrat gegenüber liegende Seite einfallende Umgebungslicht wird dabei nur kurzzeitig gemäß der gewünschten Messdauer und dem gewünschten Messintervall zugeschaltet.

Die gezeigte Spiegelvorrichtung kann mit nur einem organischen optoelektronischen Element 100 wahlweise als abdunkelbarer Spiegel mit einer beidseitigen Umgebungslichtdetektion sowie auch, wie beispielsweise in Verbindung mit Figur 1 beschrieben ist, als Lichtquelle betrieben werden.

Die im Zusammenhang mit den Figuren beschriebenen Merkmale und Ausführungsbeispiele können gemäß weiteren Ausführungsbeispielen miteinander kombiniert werden, auch wenn solche Kombinationen nicht explizit mit den einzelnen Figuren beschrieben sind.

## Patentansprüche

1. Spiegelvorrichtung, die abdunkelbar ist, aufweisend
- ein Substrat (101) mit einem elektrochromen Material, das eine steuerbare Transparenz aufweist,
- zumindest ein organisches optoelektronisches Element (100) auf dem Substrat (101), das einen organischen funktionellen Schichtenstapel (103) mit zumindest einer organischen optoelektronischen Schicht zwischen zwei Elektroden (102, 104) aufweist, die als organische Licht detektierende Schicht ausgebildet ist und die in einem ersten Betriebszustand der Spiegelvorrichtung durch das Substrat (101) Umgebungslicht (3) detektiert, so dass das organische optoelektronische Element (100) im ersten Betriebszustand als organisches Licht detektierendes Element wirkt, wobei die Transparenz des Substrats (101) in Abhängigkeit von einem Messsignal des organischen optoelektronischen Elements (100) im ersten Betriebszustand steuerbar ist, und
- eine reflektierende Schicht (120) auf einer dem Substrat (101) abgewandten Seite des organischen funktionellen Schichtenstapels (103).

2. Spiegelvorrichtung nach Anspruch 1, wobei
eine Elektrode (102) des organischen optoelektronischen Elements mit dem Substrat (101) in direktem Kontakt steht und
eine dem organischen optoelektronischen Element (100) abgewandte Bodenfläche des Substrats (101) eine Außenfläche der Spiegelvorrichtung bildet.

3. Spiegelvorrichtung nach Anspruch 1 oder 2, wobei auf dem Substrat (101) Kontaktelemente (111) zur elektrischen Ansteuerung des elektrochromen Materials angeordnet sind, in einer Richtung parallel zur Haupterstreckungsrichtung des Substrats, zum organischen optoelektronischen Element (100) beabstandet sind.

4. Spiegelvorrichtung nach Anspruch 1, wobei die reflektierende Schicht (120) die dem Substrat (101) abgewandte Elektrode (104) des organischen optoelektronischen Elements (100) aufweist.

5. Spiegelvorrichtung nach Anspruch 1, wobei die reflektierende Schicht (120) eine Spiegelschicht (115) mit einer regelbaren Reflektivität auf einer dem Substrat (101) gegenüber liegenden Seite des organischen optoelektronischen Elements (100) aufweist und die dem Substrat (101) abgewandte Elektrode (104) des organischen optoelektronischen Elements (100) transparent ausgebildet ist.

6. Spiegelvorrichtung nach einem der vorherigen Ansprüche, wobei das organische optoelektronische Element (100) als organische Fotodiode, organischer Fotoleiter und/oder organischer Fotowiderstand ausgebildet ist.

7. Spiegelvorrichtung nach einem der vorherigen Ansprüche, wobei die zumindest eine organische optoelektronische Schicht des organischen optoelektronischen Elements (100) zusätzlich als organische Licht emittierende Schicht ausgebildet ist, die in einem zweiten Betriebszustand der Spiegelvorrichtung Licht abstrahlt.

8. Spiegelvorrichtung nach Anspruch 7, wobei das organische optoelektronische Element (100) im zweiten Betriebszustand als organische Licht emittierende Diode wirkt.

9. Spiegelvorrichtung nach einem der vorherigen Ansprüche, wobei auf dem Substrat (101) in einer Richtung parallel zur Haupterstreckungsrichtung des Substrats, benachbart zum organischen optoelektronischen Element (100) zumindest ein organisches Licht emittierendes Element (200) mit einem organischen funktionellen Schichtenstapel (203) mit zumindest einer organischen Licht emittierenden Schicht zwischen zwei Elektroden (202, 204) angeordnet ist.

10. Spiegelvorrichtung nach Anspruch 9, wobei die reflektierende Schicht (120) die dem Substrat (101) abgewandte Elektrode (204) des organischen Licht emittierenden Elements (200) aufweist.

11. Spiegelvorrichtung nach einem der vorherigen Ansprüche, wobei auf dem Substrat (101) in einer Richtung parallel zur Haupterstreckungsrichtung des Substrats, benachbart zum organischen optoelektronischen Element (100) zumindest ein organisches Licht detektierendes Element (300) angeordnet ist, das Umgebungslicht (4) detektiert, das von einer dem Substrat (101) gegenüber liegenden Seite der Spiegelvorrichtung auf die Spiegelvorrichtung eingestrahlt wird.

12. Spiegelvorrichtung nach einem der vorherigen Ansprüche, wobei vom Substrat (101) aus gesehen auf dem organischen optoelektronischen Element (100) ein organisches Licht detektierendes Element (300) und/oder ein weiteres organisches optoelektronisches Element (100) angeordnet ist, das Umgebungslicht (4) detektiert, das von einer dem Substrat (101) gegenüber liegenden Seite der Spiegelvorrichtung auf die Spiegelvorrichtung eingestrahlt wird.

13. Spiegelvorrichtung nach Anspruch 12, wobei das organische Licht detektierende Element (300) zwischen zwei Elektroden (302, 304) einen organischen funktionellen Schichtenstapel (300) mit zumindest einer organischen Licht detektierenden Schicht aufweist, wobei eine der Elektroden (304) durch eine der Elektroden (104) des organischen optoelektronischen Elements (100) gebildet ist.

14. Spiegelvorrichtung nach einem der vorherigen Ansprüche, wobei das Substrat (101) ein elektrochromes Glas und/oder eine elektrochrome Folie aufweist.

15. Spiegelvorrichtung nach einem der vorherigen Ansprüche, wobei die Spiegelvorrichtung als Rückspiegel eines Kraftfahrzeugs ausgebildet ist.

## Claims

1. Mirror device which can be dimmed, comprising
- a substrate (101) comprising an electrochromic material which has a controllable transparency,
- at least one organic optoelectronic element (100) on the substrate (101), which comprises an organic functional layer stack (103) having at least one organic optoelectronic layer between two electrodes (102, 104) which is embodied as organic light detecting layer and which detects ambient light (3) through the substrate (101) in a first operating state of the mirror device, such that the organic optoelectronic element (100) acts as organic light detecting element in the first operating state, wherein the transparency of the substrate (101) is controllable depending on a measurement signal of the organic optoelectronic element (100) in the first operating state, and
- a reflective layer (120) on a side of the organic functional layer stack (103) facing away from the substrate (101).

2. Mirror device according to Claim 1, wherein
an electrode (102) of the organic optoelectronic element is in direct contact with the substrate (101), and
a base surface of the substrate (101) facing away from the organic optoelectronic element (100) forms an outer surface of the mirror device.

3. Mirror device according to Claim 1 or 2, wherein contact elements (111) for electrically driving the electrochromic material are arranged on the substrate (101), which contact elements, in a direction parallel to the main extension direction of the substrate, are spaced apart with respect to the organic optoelectronic element (100).

4. Mirror device according to Claim 1, wherein the reflective layer (120) comprises the electrode (104) of the organic optoelectronic element (100) facing away from the substrate (101).

5. Mirror device according to Claim 1, wherein the reflective layer (120) comprises a mirror layer (115) having a regulatable reflectivity on an opposite side of the organic optoelectronic element (100) relative to the substrate (101), and the electrode (104) of the organic optoelectronic element (100) facing away from the substrate (101) is embodied as transparent.

6. Mirror device according to any of the preceding claims, wherein the organic optoelectronic element (100) is embodied as an organic photodiode, an organic photoconductor and/or an organic photoresistor.

7. Mirror device according to any of the preceding claims, wherein the at least one organic optoelectronic layer of the organic optoelectronic element (100) is additionally embodied as organic light emitting layer which emits light in a second operating state of the mirror device.

8. Mirror device according to Claim 7, wherein the organic optoelectronic element (100) acts as an organic light emitting diode in the second operating state.

9. Mirror device according to any of the preceding claims, wherein at least one organic light emitting element (200) having an organic functional layer stack (203) having at least one organic light emitting layer between two electrodes (202, 204) is arranged on the substrate (101) in a direction parallel to the main extension direction of the substrate, adjacently to the organic optoelectronic element (100).

10. Mirror device according to Claim 9, wherein the reflective layer (120) comprises the electrode (204) of the organic light emitting element (200) facing away from the substrate (101).

11. Mirror device according to any of the preceding claims, wherein at least one organic light detecting element (300) is arranged on the substrate (101) in a direction parallel to the main extension direction of the substrate, adjacently to the organic optoelectronic element (100) and detects ambient light (4) which is radiated onto the mirror device from an opposite side of the mirror device relative to the substrate (101).

12. Mirror device according to any of the preceding claims, wherein an organic light detecting element (300) and/or a further organic optoelectronic element (100) are/is arranged on the organic optoelectronic element (100), as viewed from the substrate (101), and detect(s) ambient light (4) which is radiated onto the mirror device from an opposite side of the mirror device relative to the substrate (101).

13. Mirror device according to Claim 12, wherein the organic light detecting element (300) comprises between two electrodes (302, 304) an organic functional layer stack (300) having at least one organic light detecting layer, wherein one of the electrodes (304) is formed by one of the electrodes (104) of the organic optoelectronic element (100).

14. Mirror device according to any of the preceding claims, wherein the substrate (101) comprises an electrochromic glass and/or an electrochromic film.

15. Mirror device according to any of the preceding claims, wherein the mirror device is embodied as a rear-view mirror of a motor vehicle.

## Revendications

1. Dispositif à miroir pouvant être assombri, comportant
- un substrat (101) contenant un matériau électrochromique qui présente une transparence pouvant être commandée,
- au moins un élément optoélectronique organique (100) sur le substrat (101), qui présente un empilement de couches organiques fonctionnelles (103) comprenant au moins une couche optoélectronique organique entre deux électrodes (102, 104), qui est réalisé sous la forme d'une couche organique détectant la lumière et qui détecte la lumière ambiante (3) à travers le substrat (101) dans un premier état de fonctionnement du dispositif à miroir, de manière à ce que l'élément optoélectronique organique (100), dans le premier état de fonctionnement, fonctionne en tant qu'élément organique détectant la lumière, dans lequel la transparence du substrat (101) peut être commandée en fonction d'un signal de mesure de l'élément optoélectronique organique (100) dans le premier état de fonctionnement, et
- une couche réfléchissante (120) sur une face de l'empilement de couches organiques fonctionnelles (103) qui est tournée à l'opposé du substrat (101).

2. Dispositif à miroir selon la revendication 1, dans lequel
une électrode (102) de l'élément optoélectronique organique est en contact direct avec le substrat (101) et
une surface inférieure du substrat (101) qui est tournée en sens opposé à l'élément optoélectronique organique (100) forme une surface extérieure du dispositif à miroir.

3. Dispositif à miroir selon la revendication 1 ou 2, dans lequel les éléments de contact (111) sont disposés sur le substrat (101) pour commander électriquement le matériau électrochromique et sont espacés de l'élément optoélectronique organique (100) dans une direction parallèle à la direction d'extension principale du substrat.

4. Dispositif à miroir selon la revendication 1, dans lequel la couche réfléchissante (120) comporte l'électrode (104) de l'élément optoélectronique organique (100) qui est tournée en sens opposé au substrat (101).

5. Dispositif à miroir selon la revendication 1, dans lequel la couche réfléchissante (120) comporte une couche de miroir (115) ayant une réflectivité pouvant être régulée sur une face de l'élément optoélectronique organique (100) qui est opposée au substrat (101) et dans lequel l'électrode (104) de l'élément optoélectronique organique (100) qui est tournée en sens opposé au substrat (101) est réalisée de manière transparente.

6. Dispositif à miroir selon l'une quelconque des revendications précédentes, dans lequel l'élément optoélectronique organique (100) est réalisé sous la forme d'une photodiode organique, d'un photoconducteur organique et/ou d'une photorésistance organique.

7. Dispositif à miroir selon l'une quelconque des revendications précédentes, dans lequel ladite au moins une couche optoélectronique organique de l'élément optoélectronique organique (100) est en outre réalisée sous la forme d'une couche organique électroluminescente qui émet de la lumière dans un second état de fonctionnement du dispositif à miroir.

8. Dispositif à miroir selon la revendication 7, dans lequel l'élément optoélectronique organique (100) fonctionne en tant que diode électroluminescente organique dans le second état de fonctionnement.

9. Dispositif à miroir selon l'une quelconque des revendications précédentes, dans lequel au moins un élément électroluminescent organique (200) comportant un empilement de couches organique fonctionnelles (203) comprenant au moins une couche électroluminescente organique entre deux électrodes (202, 204) est disposé au voisinage de l'élément optoélectronique organique (100) sur le substrat (101) dans une direction parallèle à la direction d'extension principale du substrat.

10. Dispositif à miroir selon la revendication 9, dans lequel la couche réfléchissante (120) comporte l'électrode (204) de l'élément électroluminescent organique (200) qui est tournée en sens opposé au substrat (101).

11. Dispositif à miroir selon l'une quelconque des revendications précédentes, dans lequel un élément électroluminescent organique (300) qui détecte la lumière ambiante (4) projetée sur le dispositif à miroir depuis une face du dispositif à miroir qui est opposée au substrat (101) est disposé au voisinage de l'élément optoélectronique organique (100) sur le substrat (101) dans une direction parallèle à la direction d'extension principale du substrat.

12. Dispositif à miroir selon l'une quelconque des revendications précédentes, dans lequel un élément organique détectant la lumière (300) et/ou un autre élément optoélectronique organique (100), qui détecte la lumière ambiante (4) projetée sur le dispositif à miroir depuis une face du dispositif à miroir qui est opposée au substrat (101), est disposé sur l'élément optoélectronique organique (100) tel qu'il est vu depuis le substrat (101).

13. Dispositif à miroir selon la revendication 12, dans lequel l'élément organique détectant la lumière (300) présente, entre deux électrodes (302, 304), un empilement de couches organiques fonctionnelles (300) comprenant au moins une couche organique détectant la lumière, dans lequel l'une des électrodes (304) est formée par l'une des électrodes (104) de l'élément optoélectronique organique (100).

14. Dispositif à miroir selon l'une quelconque des revendications précédentes, dans lequel le substrat (101) comporte un verre électrochromique et/ou une feuille électrochromique.

15. Dispositif à miroir selon l'une quelconque des revendications précédentes, dans lequel le dispositif à miroir est réalisé sous la forme d'un rétroviseur d'un véhicule automobile.
